# EUROPEAN PATENT APPLICATION

(11) **EP 1 460 047 A1**
(43) Date of publication of application: **22.09.2004**
(21) Application number: 02792052.9
(22) Date of filing: 27.12.2002
(51) Int. Cl.: C03C 27/10, H01L 21/304, B08B 7/00, G02B 1/10

(54) **METHOD FOR ADHERING TRANSPARENT ARTICLES AND QUARTZ GLASS PLATE PREPARED THROUGH ADHESION AND DEVICE USING THE SAME**

(30) Priority: 27.12.2001 JP 2001397799
(71) Applicant: Onuki, Hideo, Tsukuba-shi, Ibaraki 305-0031 (JP)
(72) Inventor: Onuki, Hideo, Tsukuba-shi, Ibaraki 305-0031 (JP)
(74) Representative: Wakerley, Helen Rachael
(86) International application number: PCT/JP2002/013813
(87) International publication number: WO 2003/055820

(57) **Abstract**

As an adhering method capable of simply and easily adhering materials transparent to short-wavelength ultraviolet light, particularly quartz glass plates, with each other at room temperature and ensuring transmission of light to a short-wavelength limit inherent in quartz glass or the like, an alkoxide is used as the adhesive material and by irradiating ultraviolet light on the adhering portion, two materials are adhered. By adhering quartz glass plates in the lateral direction, a larger-area quartz glass plate can be produced. The larger-area quartz glass plate can be used as a window for separating the light source part and the cleaning chamber of a photo-cleaning apparatus.

## Description

### TECHNICAL FIELD OF THE INVENTION

The present invention relates to a method for adhering transparent materials by using an alkoxide as an adhesive material and irradiating the alkoxide portion, and also relates to an adhered large-area quartz glass plate and an apparatus using the same.

### BACKGROUND ART

When transparent materials are adhered, the short-wavelength limit of light transmitted through the materials is restricted by the short-wavelength limit of light which can be transmitted through the adhesive material used. For example, when glass bodies are adhered by using an organic adhesive, the light transmission property of the adhered glass bodies is limited by the light transmission property of the organic adhesive. The short-wavelength limit of adhesive materials currently employed is about 350 nm.

When transparency to ultraviolet light at a wavelength shorter than 350 nm is necessary, for example, a quartz glass is used. However, the dimension of one sheet of quartz glass which can be produced is limited and if quartz glass sheets are adhered by using a conventional organic adhesive, the beneficial transparency to ultraviolet light is disadvantageously lost in the adhered portion.

As for the adhering method using no adhesive material, a method of heating materials to be adhered at a high temperature and thereby melting and adhering the materials is known. However, this method has a problem in that the optical property and geometrical shape property are deteriorated due to distortion of refractive index, reduction of planarity and the like of the materials in the adhered portion.

Under these circumstances in conventional techniques, an object of the present invention is to provide a simple and high-quality adhering method capable of ensuring transmission of ultraviolet light at ever-shorter wavelengths.

As related arts, a technique of vitrifying an alkoxide into a thin film by ultraviolet light excitation is known and this technique is disclosed, for example, in Applied Physics Letter, Vol. 69, No. 4, page 482 (1996), and Japanese Unexamined Patent Publication (Kokai) Nos. 10-282339 and 10-282499. These Kokai Nos. 10-282339 and 10-282499 are an applied invention of the adhesion technique described in Applied Physics Letter, Vol. 69, No. 4, page 482 (1996) and in all of these techniques, an ultraviolet ray is irradiated on a substrate (first step), an adhesive solution is coated on the UV-irradiated portion and an ultraviolet ray is again irradiated thereon to perform the synthesis of SiO₂ (second step), thereby attaining adhesion.

The present inventors have further continued studies on the adhesion technique using an alkoxide and found that the adhesion can be attained only by the irradiation of an ultraviolet ray after the coating of the adhesive solution, and this finding leads to the accomplishment of the present invention.

Japanese Patent No. 2901963 states that this method of forming a thin film by light excitation using an alkoxide as a starting material can be applied to, for example, formation of an antireflective film on the cathode ray tube surface of a television, doping of a functional organic material, production of a photocatalyst, formation of a fine pattern film or formation of a photosensitive material or the like into a thin film.

However, these related arts are not concerned with a simple and high-quality adhering method capable of ensuring transmission of ultraviolet light at short wavelengths.

Also, a photo-cleaning apparatus using a quartz glass plate for the ultraviolet light-transmitting window is known (see, for example, Kokai No. 5-251415).
However, the existing quartz glass plate is restricted in the size and the large-sizing of the apparatus is limited.

### DISCLOSURE OF THE INVENTION

The present inventors have made intensive investigations to achieve the above-described object and confirmed that when at least one material is transparent to ultraviolet light, the materials can be adhered by using an alkoxide as an adhesive and irradiating ultraviolet light and, moreover, the adhered portion is transparent to ultraviolet light. As a result thereof, the present inventors have succeeded in developing a high-quality adhering method ensuring transparency to ultraviolet light and capable of being easily and simply performed at room temperature, in producing a large-area quartz glass plate adhered by using the method, and in providing a photo-cleaning apparatus using the large-area quartz glass plate. That is, according to the present invention, the following inventions are provided.
(1) A method for adhering transparent materials, comprising interposing an alkoxide between two materials, at least one of which comprises a medium transparent to ultraviolet light, and irradiating ultraviolet light on the alkoxide portion, thereby adhering these two materials.
(2) An adhered quartz glass plate comprising two or more quartz glass plates laterally adhered by SiO₂ to provide a larger area, with the adhered part being transparent to ultraviolet light at a wavelength shorter than 350 nm.
(3) A photo-cleaning apparatus comprising a light source part having one or a plurality of excimer lamp(s) or low-pressure mercury lamp(s), a cleaning chamber and a window for transmitting ultraviolet light provided between the light source part and the cleaning chamber, which is a photo-cleaning apparatus for cleaning a material to be cleaned by disposing the material in the cleaning chamber and irradiating thereon ultraviolet light from the light source part, wherein the adhered quartz glass plate described in (2) above is used for the window between the light source and the cleaning chamber.

### BRIEF DESCRIPTION OF THE DRAWINGS

Fig. 1 is a view showing the shape of a glass plate.
Fig. 2 is a view showing the state where ultraviolet light is irradiated on a glass plate from a light source.
Figs. 3A to 3F each is a view showing another embodiment of the method for adhering glasses of the present invention.
Fig. 4 is a view showing an embodiment of the photo-cleaning apparatus using an adhered quartz glass plate for the window.
Fig. 5 is a view showing a working example of a photo-cleaning apparatus.

### MODE FOR CARRYING OUT THE INVENTION

The method for adhering UV-transparent materials of the present invention has an object of adhering two materials with at least one material comprising a medium transparent to ultraviolet light. More exactly, the object is to provide an adhering method of adhering a medium transparent to ultraviolet light and giving an adhered part still transparent to ultraviolet light.

A representative medium transparent to ultraviolet light is quartz glass but the present invention is not limited thereto. The quartz glass transmits light even down to a wavelength of about 160 nm. Incidentally, common glass transmits only light down to a wavelength in the vicinity of 370 nm and does not come under the UV-transparent material as referred to in the present invention. The method of the present invention cannot be used and is not intended to use for such a material having no transparency to ultraviolet light. However, even if the material is not entirely composed of a UV-transparent medium, when the adhesion peripheral part is composed of a UV-transparent medium, the present invention can be of course applied.

At least one of two materials adhered by the method of the present invention must be transparent to ultraviolet light but another material is not limited to a UV-transparent material. Accordingly, the another material may be any of common glass, other glasses and various inorganic solid dielectric materials, metals, semiconductors and organic materials, such as copper plate, silicon plate, plastic plate and protein thin film.

As described above, the present invention is characterized in that materials with at least one being a UV-transparent material are adhered by using an alkoxide as the adhesive and irradiating ultraviolet light.

The present inventors have found and confirmed that the alkoxide decomposes by absorbing ultraviolet light and acts as a kind of adhesive to form bonding with glass or other inorganic or organic solid material and after the formation of adhesion, the alkoxide transmits ultraviolet light. In general, the alkoxide is presumed to be vitrified after the irradiation of ultraviolet light.

The reason why the alkoxide exhibits an adhesive activity is considered as follows. The alkoxide particularly useful for glasses is a silicon alkoxide and when a silicon alkoxide such as tetramethoxysilane (TMOS) and tetraethoxysilane (TEOS) is irradiated with ultraviolet light, the organic group is released to cause decomposition and the silicon-oxygen bond portion can form bonding with an inorganic or organic material of various types, so that adhesion either to an inorganic material or an organic material can be attained by the alkoxide. The silicon alkoxide is ideally vitrified and becomes SiO₂, but from the standpoint of the object of the present invention, complete vitrification into SiO₂ is not necessarily required and the object can be achieved if necessary adhesion and UV transparency can be obtained. A metal alkoxide such as zirconium alkoxide, titanium alkoxide, yttrium alkoxide and germanium alkoxide, an alkoxide other than these, or a mixture thereof also undertakes the same reaction. The alkoxide group is not particularly limited and may be a monomer or may be in the form of an oligomer or a polymer. As for the production conditions, suitable conditions may be selected by taking account of the coatability and the size of decomposable volatile component (organic group).

The ultraviolet light as used in the present invention means short-wavelength light at a wavelength of 350 nm or less. In the present invention, light at a wavelength shorter than 260 nm and even vacuum ultraviolet light at a wavelength shorter than 200 nm are suitably used.

The light source of ultraviolet light for use in the present invention is not limited but examples thereof include a low-pressure mercury lamp having a wavelength in the vicinity of 254 nm and 185 nm, and an excimer lamp having a wavelength in the vicinity of 172 nm. Also, radiation light including undulator can be used. The light source is sufficient if it contains ultraviolet light. A laser light source may also be used.

At the time of irradiating ultraviolet light, an ultraviolet light-absorbing material, particularly oxygen, is contained in air and therefore, in view of irradiation efficiency, the ultraviolet light is preferably irradiated after the atmosphere surrounding the materials to be adhered is at least partially purged with nitrogen or rare gas, or in vacuum.

The conditions in irradiating ultraviolet light, such as wavelength, intensity, time period, atmosphere and temperature, may be appropriately selected but unlike the glass melt-adhesion method, high-temperature heating is not necessary in the present invention and the materials to be adhered are advantageously free from thermal damage. For example, room temperature may be employed.

The method of adhering two materials by the present invention is described in greater detail below by referring to the drawings.

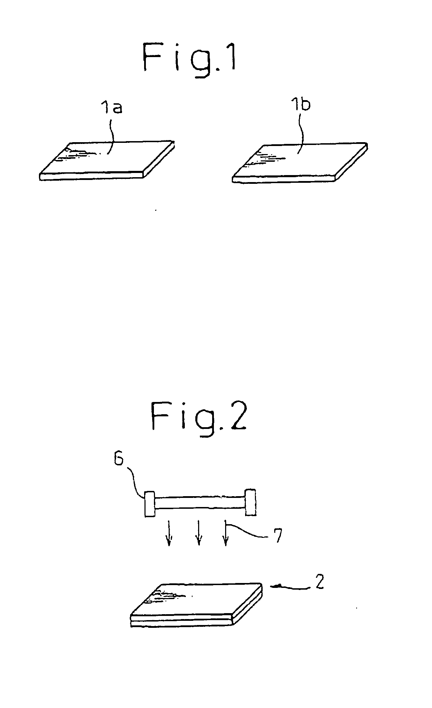

The method for adhering UV-transparent materials of the present invention can be used, for example, as shown in Figs. 1 and 2, for the adhesion of superposing and attaching two quartz glass bodies to each other. The adhesion of superposing and attaching main planes of two UV-transparent material plates to each other is apparently useful in practice, and various applications can be expected.

It was confirmed that the present invention is particularly useful for adhering two or more sheets of quartz glass in the lateral direction to prepare a larger area quartz glass plate and producing a product such that the enlarged area quartz glass plate is transparent to ultraviolet light.

For example, an excimer lamp is used in a light source apparatus for performing photo-cleaning (ultraviolet cleaning) in the process of producing a semiconductor but the excimer lamp must be placed in a nitrogen atmosphere and therefore, a quartz glass is used for the window of taking out light. In this case, the dimension of light source apparatus is restricted by the dimension of one sheet of quartz glass. However, when an adhered quartz glass having UV transparency produced by the present invention is used, the dimension is not restricted and a light source apparatus having a desired size can be produced.

Furthermore, the adhering method of the present invention can be used for attaching five quartz glass plates with each other to produce a rectangular parallelopiped quartz glass cell for use in chemical analysis or the like, for producing a quartz glass instrument, or for adhering respective elements, for example, in the production of an optical part or in the attachment of lenses with each other.

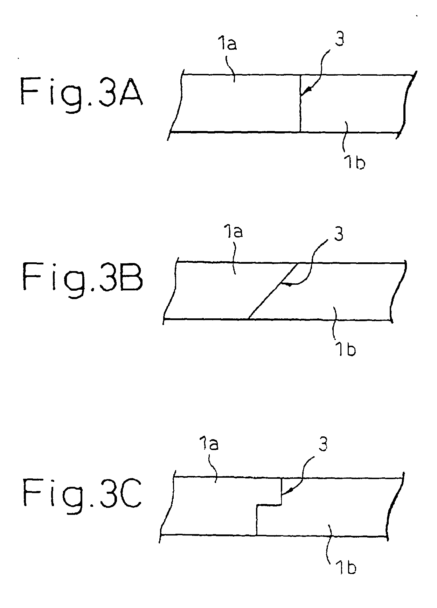

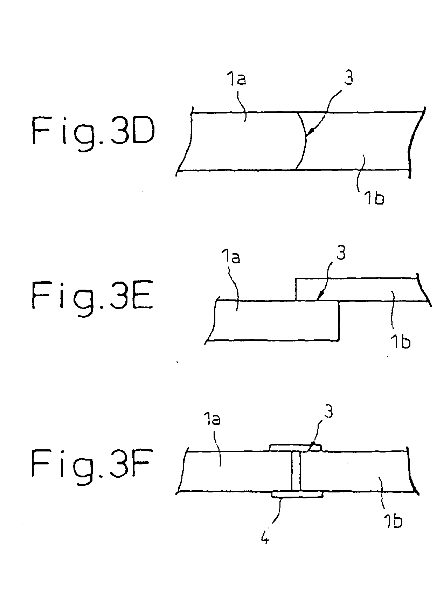

Fig. 2 and Figs. 3A to 3F show an example of the method of joining (adhering) two or more plate materials. In these Figures, 1a and 1b are a glass plate, 2 is a glass stacked body, 3 is an adhered part, 4 is a small plate for adhesion, 6 is a light source and 7 is ultraviolet light. Two glass plates 1a and 1b in various shapes may be joined (adhered) by placing these plates to face each other as shown in Figs. 3A to 3D, by superposing the edges as shown in Fig. 3E, or by using a small plate 4 for adhesion as shown in Fig. 3F.

Fundamentally, an alkoxide solution is dropped or coated on one or both of two materials, these materials are superposed or stringed and ultraviolet light is irradiated on the portion containing the alkoxide, or an alkoxide solution is injected into the space between two materials and ultraviolet light is irradiated on the portion containing the alkoxide, whereby the alkoxide can be vitrified and at the same time, caused to exert the adhesion effect and those two materials can be adhered (see Fig. 2).

The adhering method of the present invention preferably has a step of previously polishing the portions corresponding to adhesion surfaces of two materials to smooth the surfaces.

In the adhesion process, the portions corresponding to adhesion surfaces of two materials are more preferably cleaned so as to enhance the adhesive property.

In the adhesion process, a mechanical pressure is preferably applied to two materials from both sides during the irradiation of ultraviolet light on the portion containing the alkoxide, so as to enhance the adhesive property.

In the adhesive process, the ultraviolet light is preferably irradiated on two materials in a nitrogen gas or rare gas atmosphere so as to eliminate ultraviolet-absorbing molecules in air and use the ultraviolet light with good efficiency.

In this way, quartz glass plates are adhered in the lateral direction by using the adhering method of the present invention, whereby a larger-area quartz glass plate can be obtained. When the entire adhesion surfaces of quartz glass plates are adhered through SiO₂ by using the adhering method of the present invention, the adhered quartz glass plate exhibits remarkably higher adhesive strength than expected and the quartz glass plates are completely integrated with each other. This adhered quartz glass can be used as a completely one-sheet quartz glass plate without worrying about separation. When the adhered part is observed, it can be confirmed, for example, that the adhesion is formed throughout the adhesion surface, the adhesion is free of a gap (at least a void crossing over the adhesion surface is not present), and the adhered part is airtight.

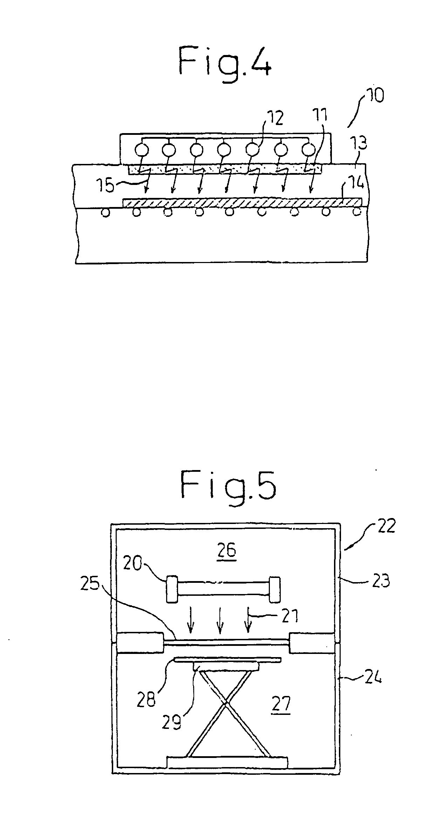

Fig. 4 shows one example of an ultraviolet light source apparatus where the adhered large-area quartz glass plate 11 obtained as above by the present invention is used for the window of transmitting light emitted from ultraviolet light sources 12. The ultraviolet light source apparatus 10 of Fig. 4 is an embodiment of the photo-cleaning apparatus, where a material 14 to be cleaned is disposed, if desired, movably disposed, in a container 13 and ultraviolet light 15 is irradiated on the material 14 to be cleaned from the ultraviolet light sources 12 through the window of the large-area quartz glass plate 11, thereby photo-cleaning the material 14. In the photo-cleaning apparatus of the present invention, the window 11 can be large-sized because the quartz glass plates are adhered to have a larger area, and therefore, the material which can be photo-cleaned by one operation is substantially free of restriction in the size and can be made extremely large, so that the photo-cleaning efficiency can be greatly enhanced.

### EXAMPLES:

The present invention is described below by referring to Examples, however, these Examples are merely one example for properly describing the invention and the present invention is not limited in any way by these Examples.

### (Example 1)

As shown in Fig. 1, two square quartz glass plates 1a and 1b having a thickness of 1 mm and a one-side length of 2 mm were prepared. On one surface of each quartz glass plate, a drop of tetramethyloxysilane (TMOS) [components: TMOS monomer: 91.8%, TMOS oligomer: 3.4%, water/methanol: 4.8%] which is an alkoxide was dripped. Then, the surfaces wetted with TMOS of quartz glasses were superposed one on another and as shown in Fig. 2, ultraviolet light 7 having a peak at a wavelength of 172 nm was irradiated on the two-sheet quartz glass plate 2 from a xenon excimer lamp 6 for 60 minutes. At this time, the distance between the xenon excimer lamp 6 and the quartz glass plate 2 was 2 mm.

As a result, the two-sheet quartz glass plates 2 were firmly adhered. The adhered two-sheet quartz glass plates 2 were measured on the absorption spectrum in the ultraviolet region. Then, absorption was exhibited in the short wavelength region of 160 nm or less. This is an absorption inherent in the quartz glass. Thus, the adhered quartz glass 2 was verified to transmit the ultraviolet light down to a wavelength of 160 nm.

### (Example 2)

Respective side faces (face of 50 mm × 4 mm) of two quartz glass plates having a size of 50 mm × 20 mm and a thickness of 4 mm were polished to give a smooth surface and after the same TMOS as used in Example 1 was coated throughout each face, the polished faces were adhered with each other in the same manner as in Example 1.

Similarly to Example 1, the adhered face of the obtained quartz glass plate transmitted ultraviolet light down to a wavelength of 160 nm.

When the adhered face of the obtained quartz glass plate was observed with a naked eye, reflection was partially observed depending on the angle and this reveals that a non-adhered portion is present. However, the non-adhered portion was small and it was confirmed that a gap crossing over the adhered face was not present.

The airtightness in the junction part was examined by a leakage detection apparatus using a helium gas, as a result, the amount of helium gas leaked per the adhered length of 1 cm was lower than the detection limit (6×10⁻¹¹ Pa·m²/s) and the junction part could be regarded as being completely airtight.

As for the heat resistance, the adhered face underwent no change and kept adhesion without causing separation even in an atmosphere of 1,000°C or more.

### (Example 3)

As shown in Fig. 5, a photo-cleaning apparatus 22 was constituted by a light source part 23, a cleaning chamber 24 and a window 25 separating these two spaces and an adhered quartz glass having a size of about 150 mm × 150 mm and a thickness of 4 mm was used for the window. A nitrogen gas 26 was steadily passed into the light source part 23 at a flow rate of about 25 L/s and an excimer lamp was laid in a nitrogen gas atmosphere. The quartz glass plate used for the window 25 was obtained by adhering two quartz glass plates having almost the same size in the same manner as in Example 2. The cleaning chamber 24 can also be made to have a nitrogen gas atmosphere 27 by steadily passing a nitrogen gas. A material 28 to be cleaned was placed on a frame 29 adjustable in the distance from the quartz glass window 25 and adjusted to an appropriate position. When the cleaning chamber 24 was atmospheric, the distance from the quartz glass window 25 was set to be from 1 to 3 mm. The illuminance of ultraviolet radiation at a wavelength of 172 nm was about 10 mW/cm² beneath the quartz glass window 25. When the material to be cleaned was a quartz glass, a sufficiently high cleaning effect was obtained by photo-cleaning for an irradiation time of 1 to 10 minutes.

### INDUSTRIAL APPLICABILITY

According to the present invention, a material transparent to ultraviolet light at a short wavelength can be adhered at room temperature and moreover, ultraviolet light can be transmitted therethrough. This adhering method can be used, for example, in producing a large-area quartz glass plate by adhering quartz glass plates in the lateral direction. The large-area quartz glass plate can be used as a window for separating the light source part and the cleaning chamber of a photo-cleaning apparatus.

## Claims

1. A method for adhering transparent materials, comprising interposing an alkoxide between two materials at least one of which comprises a medium transparent to ultraviolet light, and irradiating ultraviolet light on the alkoxide portion, thereby adhering said two materials.

2. An adhered quartz glass plate comprising two or more quartz glass plates laterally adhered by SiO₂ to provide a larger area, with the adhered part being transparent to ultraviolet light at a wavelength shorter than 350 nm.

3. A photo-cleaning apparatus comprising a light source part having one or a plurality of excimer lamp(s) or low-pressure mercury lamp(s), a cleaning chamber and a window for transmitting ultraviolet light provided between the light source part and the cleaning chamber, which is a photo-cleaning apparatus for cleaning a material to be cleaned by disposing the material in the cleaning chamber and irradiating thereon ultraviolet light from the light source part, wherein the adhered quartz glass plate claimed in claim 2 is used for the window between the light source and the cleaning chamber.
